# EUROPÄISCHE PATENTSCHRIFT

(11) **EP 3 794 641 B1**
(45) Veröffentlichungstag und Bekanntmachung des Hinweises auf die Patenterteilung: **10.07.2024**
(21) Anmeldenummer: 19724406.4
(22) Anmeldetag: 10.05.2019
(51) Int. Cl.: H01L 25/07, H01L 23/373

(54) **ENTWÄRMUNGSANORDNUNG FÜR EIN HALBLEITERLEISTUNGSMODUL**
HEAT EXTRACTION ASSEMBLY FOR A SEMICONDUCTOR POWER MODULE
DISPOSITIF D'ÉVACUATION DE CHALEUR POUR UN MODULE DE PUISSANCE À SEMI-CONDUCTEURS

(30) Priorität: 15.05.2018 DE 102018207537
(43) Veröffentlichungstag der Anmeldung: 24.03.2021
(73) Patentinhaber: Robert Bosch GmbH, 70442 Stuttgart (DE)
(72) Erfinder: SUENNER, Thomas, 70178 Stuttgart (DE); KAISER, Alexander, 72401 Haigerloch (DE); ZIPPRICH, Juergen, 72127 Kusterdingen (DE); SCHIELE, Christian, 89584 Ehingen (DE)
(86) Internationale Anmeldenummer: PCT/EP2019/062062
(87) Internationale Veröffentlichungsnummer: WO 2019/219535

(56) Entgegenhaltungen:
- WO-A2-2004/088725
- DE-T5- 112015 005 654
- US-A1- 2009 116 197
- US-A1- 2011 049 535
- US-A1- 2013 134 210

## Beschreibung

Die Erfindung betrifft eine Entwärmungsanordnung für ein Halbleiterleistungsmodul. Gegenstand der vorliegenden Erfindung sind auch ein Halbleiterleistungsmodul mit mehreren Halbleiterbauteilen und mindestens einer solchen Entwärmungsanordnung sowie ein Verfahren zum Verbinden eines Schichtstapels aus drei Fügepartnern einer solchen Entwärmungsanordnung.

Die Leistungselektronik für Hybrid-Elektrofahrzeuge bzw. Elektrofahrzeuge samt zugehöriger Halbleiterleistungsmodule sind zunehmend hohen Bauraumforderungen unterworfen, folglich werden die Halbleiterleistungsmoduls samt elektrischen Zuleitungen kleiner konstruiert. Gleichzeitig steigt die Stromdichte auf Grund gestiegener Leistungsanforderungen an. Kleinere Zuleitungen und höhere Ströme haben allerdings höhere elektrische Verluste (ohmsch als auch frequenzbehaftet) zur Folge, wodurch die Zuleitungen erwärmt werden und der Miniaturisierung eine Grenze gesetzt ist. Daher werden Leiterbahnen eines solchen Halbleiterleistungsmodul an den Leistungsanschlüssen der jeweiligen Leiterbahn oder innerhalb des Halbleiterleistungsmoduls gekühlt. Das Halbleiterleistungsmodul ist typischerweise so gebaut, dass es einen niedrigen thermischen Widerstand aufweist, also zum Kühlen gut geeignet ist. In der Regel sind die Halbleiterbauteile des Halbleiterleistungsmoduls jeweils zwischen einer Emitterleiterbahn, an welcher ein erstes Spannungspotential anliegt, und einer Kollektorleiterbahn angeordnet, an welcher ein zweites Spannungspotential anliegt. Ein erster Anschluss der Halbleiterbauteile ist jeweils mit der Kollektorleiterbahn, und ein zweiter Anschluss der Halbleiterbauteile ist jeweils mit der Emitterleiterbahn elektrisch leitend verbunden. Zudem sind die Emitterleiterbahn und die Kollektorleiterbahn jeweils mit einem externen Leistungskontakt elektrisch verbunden. Eine sogenannte B2-Brücke umfasst zwei elektrisch voneinander getrennte Kollektorleiterbahnen, auf welchen jeweils die Halbleiteiter mit einer ersten Oberfläche befestigt sind, und zwei elektrisch getrennte Emitterleiterbahnen, welche jeweils mit einer zweiten Oberfläche der Halbleiter verbunden sind. Hierbei sind die beiden Kollektorleiterbahnen in einer gemeinsamen Ebene angeordnet und mit einer Kühlvorrichtung gekoppelt, so dass die Kollektorleiterbahnen als Wärmesenke wirken. Zudem ist ein erster Leistungskontakt des Halbleiterleistungsmoduls direkt auf der Oberfläche einer ersten Kollektorleiterbahn kontaktiert und wird durch diese entwärmt. Ein zweiter Leistungskontakt des Halbleiterleistungsmoduls ist direkt auf der Oberfläche einer zweiten Kollektorleiterbahn kontaktiert und wird durch diese entwärmt. Die zweite Kollektorleiterbahn ist zudem elektrisch und mechanisch mit einer ersten Emitterleiterbahn verbunden. Ein dritter Leistungskontakt des Halbleiterleistungsmoduls ist mit einer zweiten Emitterleiterbahn verbunden und wird über einen Entwärmungspfad der aktiven Komponenten bzw. Halbleiter entwärmt. Hierzu bildet sich zwischen diesen heißen Komponenten und der Stromzuführung ein entsprechender thermischer Gradient aus. Die sich einstellende hohe Maximaltemperatur in der Stromzuführung führt zu einem größeren elektrischen Widerstand und damit zu einer Reduktion des Wirkungsgrads und zu einer Steigerung der Verlustleistung. Zudem kann sich die Lebensdauer von kritischen Komponenten des Halbleiterleistungsmodul wie beispielsweise Lötstellen, Beschichtungen, Kunststoffumspritzungen usw. reduzieren.

Bauelemente bzw. Fügepartner in der Leistungselektronik werden in der Regel durch einen Reflow-Lötprozess thermisch und elektrisch miteinander verbunden. Um komplexe Aufbauten mit mehreren Bauelementen bzw. Fügepartnern und Lötstellen kostengünstig herstellen zu können, werden sämtliche Verbindungsstellen in einem Schritt gelötet. Während dieses Prozesses kommt es zu einem Volumenschwund um ca. 50% im Lot. Dies führt zu einem Absinken des oberen Bauelements bzw. Fügepartners auf das untere Bauelement bzw. den unteren Fügepartner. In einem Schichtstapel aus drei Fügepartnern, in welchem der obere und untere Fügepartner in ihrer Höhe fixiert sind, ist ein solches Absinken konstruktionsbedingt nicht möglich. Durch den Volumenschwund während des Lötprozesses kann es hierdurch zu einer reduzierten Lot-Anbindungsfläche und/oder zur Ausbildung von Lunkern kommen. Diese kann zu einem erhöhten elektrischen und thermischen Widerstand und dadurch zu reduzierter Funktionalität bis zu reduzierter Lebensdauer führen.

Aus der DE 10 2009 006 152 A1 ist ein Elektronikbauelement bekannt, welches einen Systemträger, einen ersten Hableiterchip, einen zweiten Halbleiterchip und einen metallischen Clip umfasst, welche von einem Moldgehäuse umgeben sind. Der erste Halbleiterchip ist mit einer ersten Oberfläche auf dem Systemträger aufgebracht. Der metallische Clip ist S-förmig gebogen und verbindet eine zweite Oberfläche des ersten Halbleiterchips, welche der ersten Oberfläche gegenüberliegt, mit einer ersten Oberfläche des zweiten Halbleiterchips, wobei die erste Oberfläche des zweiten Halbleiters in einer anderen Ebene des Elektronikbauelements angeordnet ist. Eine zweite Oberfläche des zweiten Halbleiterchips kann mit einem zweiten metallischen Clip verbunden werden. Die metallischen Clips können durch Stanzen, Prägen, Pressen, Schneiden, Sägen, Fräsen hergestellt werden.

Aus der Offenlegungsschrift der DE 11 2015 005 654 T5 ist eine Leistungseinheit umfassend ein IGBT-Modul gezeigt. Das IGB-Modul weist dabei einen IGBT-Halbleiterelement auf, welches auf einer isolierten Leiterplatte angeordnet ist. Das IGBT-Modul ist dabei bis auf eine Anschlussseite ummoldet. Mit der Anschlussseite ist das IGBT-Modul mit einer Wärmesenke verbunden. Ein Oberseitenkontakt des Halbleiterelementes ist mit einem Verdrahtungselement verlötet, welches aus dem Moldmaterial herausragt.

Die Offenlegungsschrift WO04088725A zeigt eine Lotverbindungsanordnung. Diese umfasst ein Substrat, auf dessen ersten Hauptseite ein erstes Diffusionslot mit einer ersten Schmelztemperatur und auf dessen zweiten Hauptseite ein zweites Diffusionslot mit einer zweiten Schmelztemperatur aufgebracht sind. Die beiden Schmelztemperaturen unterscheiden sich.

In der Offenlegungsschrift US 2013/0134210 A1 ist eine Kontaktanordnung umfassend einen Halbleiterchip gezeigt. Dessen Oberseitenkontakt ist mit einem Anschlusselement verlötet, wobei das Anschlusselement im Lotbereich eine Aussparung aufweist, innerhalb welcher ein Lötauge des Lotmaterials angeordnet ist. Offenbarung der Erfindung

Die Entwärmungsanordnung für ein Halbleiterleistungsmodul mit den Merkmalen des unabhängigen Patentanspruchs 1 hat den Vorteil, dass ein Entwärmungspfad ohne elektrisch leitende Verbindung bzw. Kurzschluss zwischen zwei elektrisch leitenden Fügepartnern mit unterschiedlichen Spannungspotentialen ausgebildet werden kann. Durch Ausführungsformen der erfindungsgemäßen Entwärmungsanordnung ist es möglich, einen externen Leistungskontakt des Halbleitermoduls, welcher nicht direkt auf der Oberfläche einer als Wärmesenke wirkenden Leiterbahn kontaktiert ist, thermisch mit der als Wärmesenke wirkenden Leiterbahn zu koppeln und über den ausgebildeten Entwärmungspfad zu entwärmen. Dadurch können auch solche externen Leistungskontakte des Halbleiterleistungsmoduls gekühlt und die Verlustleistung über den Entwärmungspfad des Halbleiterleistungsmoduls abgeführt werden. Das Halbleiterleistungsmodul ist typischerweise so gebaut, dass es einen niedrigen thermischen Widerstand aufweist und zum Kühlen gut geeignet ist. Durch die erfindungsgemäße Entwärmungsanordnung wird der externe Leistungskontakt thermisch an das Kühlsystem des Halbleiterleistungsmoduls angekoppelt, so dass eine definierte Entwärmung des externen Leistungskontakts möglich ist. Ausführungsformen der erfindungsgemäßen Entwärmungsanordnung weisen geringe mechanische Toleranzen, eine gute bis sehr gute thermische Leitfähigkeit auf und sind elektrisch Isolierend ausgeführt. Dadurch wird die thermische Leistungsfähigkeit des Halbleiterleistungsmodul in vorteilhafter Weise von durch außen eingeprägte Verlustleistung entkoppelt. Außerdem erfahren die Halbleiter keinen zusätzlichen Wärmeeintrag durch die Anbindung an externe Stromschienen und können dadurch optimaler ausgenutzt werden. Die Halbleiterbauteile können beispielsweise als IGBTs (insulated Gate Bipolar Transistors), MOSFET (Metal-Oxide-Semiconductor Field-Effect Transistor, Metall-Oxid-Halbleiter-Feldeffekttransistor), usw. ausgeführt werden.

Ausführungsformen der vorliegenden Erfindung stellen eine Entwärmungsanordnung für ein Halbleiterleistungsmodul, mit drei gestapelten Fügepartnern zur Verfügung, welche durch eine erste Lotschicht und durch eine zweite Lotschicht stoffschlüssig miteinander verbunden sind. Die erste Lotschicht ist zwischen einem elektrisch leitenden ersten Fügepartner und einem elektrisch isolierenden mittleren Fügepartner ausgebildet. Die zweite Lotschicht ist zwischen dem elektrisch isolierenden mittleren Fügepartner und einem elektrisch leitenden zweiten Fügepartner ausgebildet. Der erste Fügepartner ist eine zu entwärmende erste Leiterbahn, an welcher ein erstes Spannungspotential anliegt, und der zweite Fügepartner ist eine als Wärmesenke wirkende zweite Leiterbahn, an welcher ein vom ersten Spannungspotential verschiedenes zweites Spannungspotential anliegt. Hierbei ist der mittlere Fügepartner eine elektrisch isolierende Zwischenschicht, welche einen elektrisch isolierten Wärmeableitpfad zwischen dem ersten Fügepartner und dem zweiten Fügepartner ausbildet.

Zudem wird ein Halbleiterleistungsmodul mit mehreren Halbleiterbauteilen und mindestens einer solchen Entwärmungsanordnung vorgeschlagen. Hierbei sind die Halbleiterbauteile jeweils zwischen einer Emitterleiterbahn, an welcher ein erstes Spannungspotential anliegt, und einer als Wärmesenke wirkenden Kollektorleiterbahn angeordnet, an welcher ein zweites Spannungspotential anliegt. Die mindestens eine Entwärmungsanordnung bildet einen elektrisch isolierten Entwärmungspfad zwischen der Emitterleiterbahn und der als Wärmesenke wirkenden Kollektorleiterbahn aus.

So kann beispielsweise ein zu entwärmender externer Leistungskontakt mit der Emitterleiterbahn verbunden sein, und ein weiterer externer Leistungskontakt kann mit der als Wärmesenke wirkenden Kollektorleiterbahn verbunden sein und durch diese entwärmt werden. Die mindestens eine Entwärmungsanordnung kann dann im Bereich des zu entwärmenden externen Leistungskontakts angeordnet werden und einen elektrisch isolierten Entwärmungspfad zwischen der mit dem ersten Leistungskontakt verbundenen Emitterleiterbahn und der als Wärmesenke wirkenden Kollektorleiterbahn ausbilden.

Der elektrisch isolierende mittlere Fügepartner weist eine lötbare und/oder sinterbare Oberfläche auf und befindet sich innerhalb des Halbleiterleistungsmodul stoffschlüssig angebunden zwischen dem externen Leistungskontakt als Stromzuführung und der Oberfläche der als Wärmesenke wirkenden Leiterbahn, auf welcher auch die Halbleiter angeordnet und befestigt sind. Der elektrisch isolierende mittlere Fügepartner stellt die elektrische Isolation der unterschiedlichen Spannungspotentiale des externen Leistungskontakts und der als Wärmesenke wirkenden Leiterbahn sicher und kann beispielsweise als DBC-Substrat, AMB-Keramiksubstrat oder IMS-Substrat ausgeführt werden. Zur Einhaltung von sehr engen Toleranzen kann auch ein Stück entsprechend bearbeitetes Reinstsilizium als mittlerer Fügepartner verwendet werden, welches analog wie die andere Halbleiter des Halbleiterleistungsmoduls gefertigt werden kann. Die drei Fügepartnern des Schichtstapels der erfindungsgemäßen Entwärmungsanordnung können mit den anderen Halbleitern des Halbleiterleistungsmoduls in einem gemeinsamen Reflow-Lötprozess miteinander verbunden werden.

Des Weiteren wird ein Verfahren zum Verbinden eines Schichtstapels aus drei Fügepartnern einer solchen Entwärmungsanordnung vorgeschlagen, bei welcher der als zu entwärmende erste Leiterbahn ausgeführte elektrisch leitende erste Fügepartner und der als zweite Leiterbahn ausgeführte und als Wärmesenke wirkende elektrisch leitende zweite Fügepartner in ihrer Höhe fixiert sind und einen vorgegebenen Abstand zueinander aufweisen. Das Verfahren umfasst die Schritte: Aufbringen einer ersten Lotpaste, deren erstes Lotmittel eine erste Schmelztemperatur aufweist, auf eine lötbare Oberfläche des elektrisch leitenden ersten Fügepartners und auf eine erste lötbare Oberfläche des elektrisch isolierenden mittleren Fügepartners, so dass ein Spalt zwischen dem ersten Fügepartner und dem mittleren Fügepartner mit der ersten Lotpaste gefüllt ist. Auffüllen einer nach oben offenen Lotausgleichsöffnung im ersten Fügepartner mit der ersten Lotpaste. Aufbringen einer zweiten Lotpaste, deren zweites Lotmittel eine höhere zweite Schmelztemperatur aufweist, auf eine zweite lötbare Oberfläche des mittleren Fügepartners und auf eine lötbare Oberfläche des zweiten Fügepartners, so dass ein Spalt zwischen dem mittleren Fügepartner und dem zweiten Fügepartner mit der zweiten Lotpaste gefüllt ist. Erhitzen des Schichtstapels in einem Reflow-Lötofen auf eine Temperatur, welche höher als die zweite Schmelztemperatur ist, und anschließendes Abkühlen des Schichtstapels, so dass während der Abkühlphase zunächst die zweite Lotschicht erstarrt, während die erste Lotschicht noch schmelzflüssig ist, und es zu einem Absinken des mittleren Fügepartners und einer vollflächigen Anbindung des mittleren Fügepartners an den zweiten Fügepartner kommt, wobei der nun größere Spalt zwischen dem mittleren Fügepartner und dem ersten Fügepartner mit dem schmelzflüssigen Lotmittel aus der nach oben offenen Lotausgleichsöffnung nachgefüllt wird, so dass es unter Aussparung der Lotausgleichsöffnung zu eine vollflächigen Anbindung des mittleren Fügepartners an den ersten Fügepartner kommt.

Als erstes Lotmittel kann beispielsweise ein Zinn-Silber-Kupfer-Lot (SAC) verwendet werden. Als zweites Lotmittel kann beispielsweise ein Zinn-Kupfer-Lot (SnCu) verwendet werden, welches eine höhere Schmelztemperatur als das Zinn-Silber-Kupfer-Lot (SAC) aufweist und während des Abkühlvorgangs zuerst erstarrt.

Durch die in den abhängigen Ansprüchen aufgeführten Maßnahmen und Weiterbildungen sind vorteilhafte Verbesserungen der im unabhängigen Patentanspruch 1 angegebenen Entwärmungsanordnung für ein Halbleiterleistungsmodul möglich.

Besonders vorteilhaft ist, dass die elektrisch isolierende Zwischenschicht eine gute bis sehr gute Wärmeleitfähigkeit im Bereich von 20 bis 200 W/mK aufweisen kann.

In weiterer vorteilhafter Ausgestaltung der Entwärmungsanordnung können der erste Fügepartner und der zweite Fügepartner in ihrer Höhe fixiert sein und einen vorgegebenen Abstand zueinander aufweisen.

Grundsätzlich ist in der erfindungsgemäßen Entwärmungsanordnung die erste Lotschicht aus einem ersten Lotmittel mit einer ersten Schmelztemperatur ausgebildet werden, und die zweite Lotschicht ist aus einem zweiten Lotmittel mit einer höheren zweiten Schmelztemperatur ausgebildet. Des Weiteren weist der erste Fügepartner eine nach oben offene mit dem ersten Lotmittel gefüllte Lotausgleichsöffnung auf, aus welcher das erste Lotmittel zur Anfüllung des Spalts zwischen dem ersten Fügepartner und dem mittleren Fügepartner in den Spalt nachfließen kann. Durch die mit dem ersten Lotmittel gefüllte Lotausgleichsöffnung und durch die Wahl geeigneter Lotmittel und Geometrien der Fügepartner kann ein Volumenschwund des Lotmittels während des Lötprozesses in dem Schichtstapel aus drei Fügepartnern ausgeglichen werden. Dadurch kann eine hinreichende große Anbindungsfläche der Fügepartner zueinander gewährleistet und in vorteilhafter Weise eine optimale thermische Anbindung und ein stoffschlüssiger Verguss hergestellt werden, welcher im Fall von thermomechanischer Beanspruchung nicht zu einer elektrischen Degradation führt. Somit kann die Funktionalität des Aufbaus hinsichtlich thermischer Entwärmung über alle Toleranzlagen hinweg in vorteilhafter Weise sichergestellt werden. So kann die nach oben offene Lotausgleichsöffnung beispielsweise ein Volumen aufweisen, welches mindestens doppelt so groß wie ein Volumen des Spalts zwischen dem ersten Fügepartner und dem mittleren Fügepartner ist. Dadurch kann in vorteilhafter Weise sichergestellt werden, dass auch bei einem großen Volumenschwund eine ausreichende Menge an erstem Lotmittel in den Spalt zwischen dem ersten Fügepartner und dem mittleren Fügepartner nachfließen kann.

In weiterer vorteilhafter Ausgestaltung der Entwärmungsanordnung kann die erste Lotschicht unter Aussparung der Lotausgleichsöffnung vollflächig zwischen einer lötbaren Oberfläche des ersten Fügepartners und einer lötbaren ersten Oberfläche des mittleren Fügepartners ausgebildet. Dadurch ist die nach oben offene Lotausgleichsöffnung oberhalb der lötbaren ersten Oberfläche des mittleren Fügepartners ausgebildet, so dass das erste Lotmittel während des Lötvorgangs direkt in den Spalt zwischen dem ersten Fügepartner und dem mittleren Fügepartner nachfließen kann. Die zweite Lotschicht kann vollflächig zwischen einer lötbaren zweiten Oberfläche des mittleren Fügepartners und einer lötbaren Oberfläche des zweiten Fügepartners ausgebildet werden. Durch die vollflächige stoffschlüssige Anbindung der einzelnen Fügepartner zueinander kann in vorteilhafter Weise eine optimale thermische Anbindung und ein stoffschlüssiger Verguss hergestellt werden, welcher im Fall von thermomechanischer Beanspruchung nicht zu einer elektrischen Degradation führt.

In weiterer vorteilhafter Ausgestaltung der Entwärmungsanordnung kann der mittlere Fügepartner beispielsweise ein DBC-Substrat oder ein AMB-Keramiksubstrat oder ein IMS-Substrat oder ein Reinstsilizium-Stück sein. Hierbei kann eine erste Kupferstruktur die erste lötbare Oberfläche des mittleren Fügepartners ausbilden, und eine zweite Kupferstruktur kann die zweite lötbare Oberfläche des mittleren Fügepartners ausbilden.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

### Kurze Beschreibung der Zeichnungen

Fig. 1 zeigt eine schematische Draufsicht auf ein Ausführungsbeispiel eines erfindungsgemäßen Halbleiterleistungsmoduls mit einem Ausführungsbeispiel einer erfindungsgemäßen Entwärmungsanordnung.

Fig. 2 zeigt eine schematische Schnittdarstellung der erfindungsgemäßen Entwärmungsanordnung für ein Halbleiterleistungsmodul aus Fig. 1 entlang der Schnittlinie II - II.

### Ausführungsformen der Erfindung

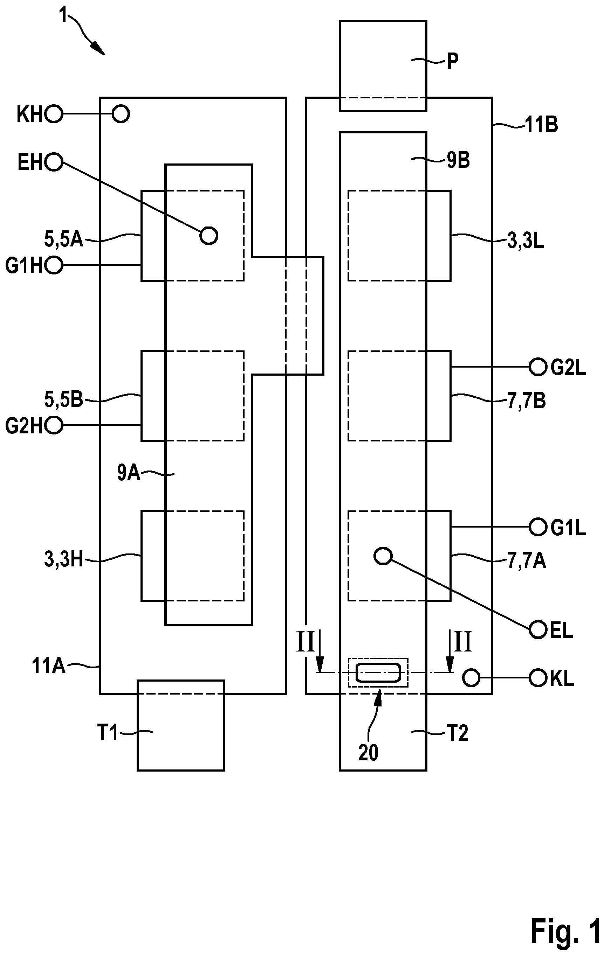

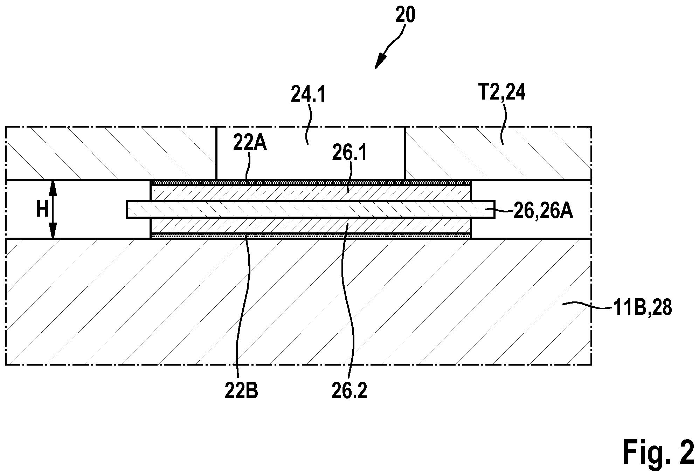

Wie aus Fig. 1 und 2 ersichtlich ist, umfasst das dargestellte Ausführungsbeispiel einer erfindungsgemäßen Entwärmungsanordnung 20 für ein Halbleiterleistungsmodul 1 drei gestapelte Fügepartner 24, 26, 28, welche durch eine erste Lotschicht 22A und durch eine zweite Lotschicht 22B stoffschlüssig miteinander verbunden sind. Die erste Lotschicht 22A ist zwischen einem elektrisch leitenden ersten Fügepartner 24 und einem elektrisch isolierenden mittleren Fügepartner 26 ausgebildet. Die zweite Lotschicht 22B ist zwischen dem elektrisch isolierenden mittleren Fügepartner 26 und einem elektrisch leitenden zweiten Fügepartner 28 ausgebildet. Hierbei ist der erste Fügepartner 24 eine zu entwärmende erste Leiterbahn des Halbleiterleistungsmoduls 1, an welcher ein erstes Spannungspotential anliegt. Der zweite Fügepartner 28 ist eine als Wärmesenke wirkende zweite Leiterbahn des Halbleiterleistungsmoduls 1, an welcher ein vom ersten Spannungspotential verschiedenes zweites Spannungspotential anliegt. Der mittlere Fügepartner 26 ist eine elektrisch isolierende Zwischenschicht 26A, welche einen elektrisch isolierten Wärmeableitpfad zwischen dem ersten Fügepartner 24 und dem zweiten Fügepartner 28 ausbildet.

Wie aus Fig. 1 weiter ersichtlich ist, ist das Halbleiterleistungsmodul 1 im dargestellten Ausführungsbeispiel als B2-Brücke ausgeführt und umfasst vier als IGBT (IGBT: Insulated Gate Bipolar Transistor - Bipolartransistoren mit isoliertem Gate) ausgeführte Halbleiterbauteile 5, 7 und zwei als Freilaufdioden 2 ausgeführte Halbleiterbauteile 3. Wie aus Fig. 1 weiter ersichtlich ist, sind im dargestellten Ausführungsbeispiel zwei IGBTs 5A, 5B und eine Freilaufdiode 3H zwischen einer ersten Kollektorleiterbahn 11A und einer ersten Emitterleiterbahn 9A angeordnet und bilden eine High-Side des Halbleiterbauteils 1. Zudem sind im dargestellten Ausführungsbeispiel zwei IGBTs 7A, 7B und eine Freilaufdiode 3L zwischen einer zweiten Kollektorleiterbahn 11B und einer zweiten Emitterleiterbahn 9B angeordnet und bilden eine Low-Side des Halbleiterbauteils 1. Die beiden Kollektorleiterbahnen 11A, 11B sind beabstandet zueinander in der gleichen Ebene angeordnet und mit einer nicht dargestellten Kühlvorrichtung gekoppelt. Daher wirken die beiden Kollektorleiterbahnen 11A, 11B jeweils als Wärmesenke zur Entwärmung des Halbleiterleistungsmoduls 1. Die Halbleiterbauteile 5A, 5B, 7A, 7B, 3H, 3L sind auf den Kollektorleiterbahnen 11A, 11B angeordnet, wobei ein erster Anschluss der Halbleiterbauteile 5A, 5B, 7A, 7B, 3H, 3L jeweils mit einer korrespondierenden Kollektorleiterbahn 11A, 11B elektrisch leitend verbunden ist. Ein zweiter Anschluss der Halbleiterbauteile 5A, 5B, 7A, 7B, 3H, 3L ist jeweils mit einer korrespondierenden Emitterleiterbahn 9A, 9B elektrisch leitend verbunden. Zudem werden die Halbleiterbauteile 5A, 5B, 7A, 7B, 3H, 3L über die jeweilige Kollektorleiterbahn 11A, 11B entwärmt.

Selbstverständlich kann die erfindungsgemäßen Entwärmungsanordnung 20 in beliebigen Halbleiterleistungsmodulen 1 eingesetzt werden und ist nicht auf die Verwendung in einer B2-Brücke beschränkt.

Wie aus Fig. 1 weiter ersichtlich ist, ist ein erster externer Leistungskontakt T1, an welchem ein erstes Gleichspannungspotential anliegt mit der Oberfläche der ersten Kollektorleiterbahn 11A verbunden und wird durch diese entwärmt. Die erste Emitterleiterbahn 9A ist elektrisch mit der zweiten Kollektorleiterbahn 11B verbunden. Ein zweiter externer Leistungskontakt T2, an welchem ein zweites Gleichspannungspotential anliegt, ist mit der zweiten Emitterleiterbahn 9B verbunden und wird durch die erfindungsgemäße Entwärmungsanordnung 20 entwärmt. Ein dritter Leistungskontakt P, an welchem ein Wechselspannungspotential anliegt, ist mit der Oberfläche der zweiten Kollektorleiterbahn 11B verbunden und wird durch diese entwärmt. Zudem weist das dargestellte Halbleiterleistungsmodul 1 noch weiter externe Kontakte KH, EH, G1H, G2H, KL, EL, G1L, G2L auf. Hierbei ist der externe Kontakt KH über einen Bonddraht mit der ersten Kollektorleiterbahn 11A bzw. den Kollektoranschlüssen der IGBTs 5A, 5B der High-Side des Halbleiterleistungsmodul 1 verbunden. Der externe Kontakt EH ist über einen Bonddraht mit der ersten Emitterleiterbahn 9A bzw. den Emitteranschlüssen der IGBTs 5A, 5B der High-Side des Halbleiterleistungsmoduls 1 verbunden. Der externe Kontakt G1H ist über einen Bonddraht mit dem Gateanschluss des ersten IGBT 5A der High-Side des Halbleiterleistungsmoduls 1 verbunden. Der externe Kontakt G2H ist über einen Bonddraht mit dem Gateanschluss des zweiten IGBT 5B der High-Side des Halbleiterleistungsmoduls 1 verbunden. Analog ist der externe Kontakt K L über einen Bonddraht mit der zweiten Kollektorleiterbahn 11B bzw. den Kollektoranschlüssen der IGBTs 7A, 7B der Low-Side des Halbleiterleistungsmoduls 1 verbunden. Der externe Kontakt EL ist über einen Bonddraht mit der zweiten Emitterleiterbahn 9B bzw. den Emitteranschlüssen der IGBTs 7A, 7B der Low-Side des Halbleiterleistungsmoduls 1 verbunden. Der externe Kontakt G1L ist über einen Bonddraht mit dem Gateanschluss des ersten IGBT 7A der Low-Side des Halbleiterleistungsmoduls 1 verbunden. Der externe Kontakt G2L ist über einen Bonddraht mit dem Gateanschluss des zweiten IGBT 7B der Low-Side des Halbleiterleistungsmoduls 1 verbunden.

Wie aus Fig. 1 und 2 weiter ersichtlich ist, ist die Entwärmungsanordnung 20 im Bereich des zu entwärmenden zweiten externen Leistungskontakts T2 angeordnet und bildet einen elektrisch isolierten Entwärmungspfad zwischen der mit dem zweiten Leistungskontakt T2 verbundenen Emitterleiterbahn 9B und der als Wärmesenke wirkenden zweiten Kollektorleiterbahn 11B aus.

Im dargestellten Ausführungsbeispiel ist die elektrisch isolierende Zwischenschicht 26A bzw. der mittlere Fügepartner 26 als AMB-Keramiksubstrat ausgeführt und weist eine gute bis sehr gute Wärmeleitfähigkeit im Bereich von 20 bis 200 W/mK auf. Selbstverständlich kann die elektrisch isolierende Zwischenschicht 26A bzw. der mittlere Fügepartner 26 alternativ als DBC-Substrat oder als IMS-Substrat oder als Reinstsilizium-Stück ausgeführt werden.

Wie aus Fig. 1 und 2 weiter ersichtlich ist, sind der erste Fügepartner 24 bzw. der zweite externe Leistungskontakt T2 und der zweite Fügepartner 28 bzw. die zweite Kollektorleiterbahn 11B in ihrer Höhe fixiert und weisen einen vorgegebenen Abstand H zueinander auf. Zudem ist die erste Lotschicht 22A aus einem ersten Lotmittel mit einer ersten Schmelztemperatur ausgebildet, und die zweite Lotschicht 22B ist aus einem zweiten Lotmittel mit einer höheren zweiten Schmelztemperatur ausgebildet. Des Weiteren weist der erste Fügepartner 24 bzw. der externe Leistungskontakt T2 eine nach oben offene mit dem ersten Lotmittel gefüllte Lotausgleichsöffnung 14 auf, aus welcher das erste Lotmittel zur Anfüllung des Spalts zwischen dem ersten Fügepartner 24 bzw. dem externen LeistungskontaktT2 und dem mittleren Fügepartner 26 in den Spalt nachfließt. Daher bildet sich die erste Lotschicht 22A im dargestellten Ausführungsbeispiel unter Aussparung der Lotausgleichsöffnung 24.1 vollflächig zwischen einer lötbaren Oberfläche des ersten Fügepartners 24 und einer lötbaren ersten Oberfläche 26.1 des mittleren Fügepartners 26 aus. Die zweite Lotschicht 22B bildet sich vollflächig zwischen einer lötbaren zweiten Oberfläche 26.2 des mittleren Fügepartners 26 und einer lötbaren Oberfläche des zweiten Fügepartners 28 aus. Im dargestellten Ausführungsbeispiel bildet eine erste Kupferstruktur die erste lötbare Oberfläche 26.1 des mittleren Fügepartners 26 aus, und eine zweite Kupferstruktur bildet die zweite lötbare Oberfläche 26.2 des mittleren Fügepartners 26 aus.

Das erfindungsgemäße Verfahren zum Verbinden eines Schichtstapels aus drei Fügepartnern 24, 26, 28 einer erfindungsgemäßen Entwärmungsanordnung 20, bei welcher der als zu entwärmende erste Leiterbahn ausgeführte elektrisch leitende erste Fügepartner 24 und der als zweite Leiterbahn ausgeführte und als Wärmesenke wirkende elektrisch leitende zweite Fügepartner 28 in ihrer Höhe fixiert sind und einen vorgegebenen Abstand H zueinander aufweisen, umfasst die Schritte: Aufbringen einer ersten Lotpaste, deren erstes Lotmittel eine erste Schmelztemperatur aufweist, auf die lötbare Oberfläche des elektrisch leitenden ersten Fügepartners 24 und auf die erste lötbare Oberfläche 26.1 des elektrisch isolierenden mittleren Fügepartners 28, so dass ein Spalt zwischen dem ersten Fügepartner 24 und dem mittleren Fügepartner 26 mit der ersten Lotpaste gefüllt ist. Auffüllen der nach oben offenen Lotausgleichsöffnung 24.1 im ersten Fügepartner 24 mit der ersten Lotpaste. Aufbringen einer zweiten Lotpaste, deren zweites Lotmittel eine höhere zweite Schmelztemperatur aufweist, auf die zweite lötbare Oberfläche 26.2 des mittleren Fügepartners 26 und auf die lötbare Oberfläche des zweiten Fügepartners 28, so dass ein Spalt zwischen dem mittleren Fügepartner 26 und dem zweiten Fügepartner 28 mit der zweiten Lotpaste gefüllt ist. Erhitzen des Schichtstapels in einem Reflow-Lötofen auf eine Temperatur, welche höher als die zweite Schmelztemperatur ist, und anschließendes Abkühlen des Schichtstapels, so dass während der Abkühlphase zunächst die zweite Lotschicht 22B erstarrt, während die erste Lotschicht 22A noch schmelzflüssig ist, und es zu einem Absinken des mittleren Fügepartners 26 und einer vollflächigen Anbindung des mittleren Fügepartners 26 an den zweiten Fügepartner 28 kommt, wobei der nun größere Spalt zwischen dem mittleren Fügepartner 26 und dem ersten Fügepartner 24 mit dem schmelzflüssigen Lotmittel aus der nach oben offenen Lotausgleichsöffnung 24.1 nachgefüllt wird, so dass es unter Aussparung der Lotausgleichsöffnung 24.1 zu eine vollflächigen Anbindung des mittleren Fügepartners 26 an den ersten Fügepartner 24 kommt.

Fig. 2 zeigt den Schichtstapel aus drei Fügepartnern 10, 20, 30 nach dem Lötvorgang. Wie aus Fig. 2 weiter ersichtlich ist, ist das vor dem Lötvorgang in die Lotausgleichsöffnung 14 eingebrachte erste Lotmittel nahezu vollständig in den Spalt zwischen dem oberen Fügepartner 10 und dem mittleren Fügepartner 20 geflossen, um den Volumenverlust des ersten Lotmittels und das Absinken des mittleren Fügepartners 20 während des Lötvorgangs im Reflow-Lötofen auszugleichen.

## Patentansprüche

1. Entwärmungsanordnung (20) für ein Halbleiterleistungsmodul (1), mit drei gestapelten Fügepartnern (24, 26, 28), welche durch eine erste Lotschicht (22A) und durch eine zweite Lotschicht (22B) stoffschlüssig miteinander verbunden sind, wobei die erste Lotschicht (22A) zwischen einem elektrisch leitenden ersten Fügepartner (24) und einem elektrisch isolierenden mittleren Fügepartner (26) ausgebildet ist, und die zweite Lotschicht (22B) zwischen dem elektrisch isolierenden mittleren Fügepartner (26) und einem elektrisch leitenden zweiten Fügepartner (28) ausgebildet ist, wobei der erste Fügepartner (24) eine zu entwärmende erste Leiterbahn ist, an welcher ein erstes Spannungspotential anliegen kann, wobei der zweite Fügepartner (28) eine als Wärmesenke wirkende zweite Leiterbahn ist, an welcher ein vom ersten Spannungspotential verschiedenes zweites Spannungspotential anliegen kann, und wobei der mittlere Fügepartner (26) eine elektrisch isolierende Zwischenschicht (26A) aufweist, welche einen elektrisch isolierten Wärmeableitpfad zwischen dem ersten Fügepartner (24) und dem zweiten Fügepartner (28) ausbildet,
**dadurch gekennzeichnet, dass**
dass die erste Lotschicht (22A) aus einem ersten Lotmittel mit einer ersten Schmelztemperatur ausgebildet ist, und die zweite Lotschicht (22B) aus einem zweiten Lotmittel mit einer höheren zweiten Schmelztemperatur ausgebildet ist, und wobei der erste Fügepartner (24) eine nach oben offene mit dem ersten Lotmittel gefüllte Lotausgleichsöffnung (14) aufweist, aus welcher das erste Lotmittel zur Anfüllung des Spalts zwischen dem ersten Fügepartner (24) und dem mittleren Fügepartner (26) in den Spalt nachfließen kann.

2. Entwärmungsanordnung (20) nach Anspruch 1, **dadurch gekennzeichnet, dass** die elektrisch isolierende Zwischenschicht (26A) eine gute bis sehr gute Wärmeleitfähigkeit im Bereich von 20 bis 200 W/mK aufweist.

3. Entwärmungsanordnung (20) nach Anspruch 1 oder 2, **dadurch gekennzeichnet, dass** der erste Fügepartner (24) und der zweite Fügepartner (28) in ihrer Höhe fixiert sind und einen vorgegebenen Abstand (H) zueinander aufweisen.

4. Entwärmungsanordnung (20) nach Anspruch 3, **dadurch gekennzeichnet, dass** die erste Lotschicht (22A) unter Aussparung der Lotausgleichsöffnung (24.1) vollflächig zwischen einer lötbaren Oberfläche des ersten Fügepartners (24) und einer lötbaren ersten Oberfläche (26.1) des mittleren Fügepartners (26) ausgebildet ist.

5. Entwärmungsanordnung (20) nach Anspruch 3 oder 4, **dadurch gekennzeichnet, dass** die zweite Lotschicht (22B) vollflächig zwischen einer lötbaren zweiten Oberfläche (26.2) des mittleren Fügepartners (26) und einer lötbaren Oberfläche des zweiten Fügepartners (28) ausgebildet ist.

6. Entwärmungsanordnung (20) nach einem der Ansprüche 1 bis 5, **dadurch gekennzeichnet, dass** der mittlere Fügepartner (26) ein DBC-Substrat oder ein AMB-Keramiksubstrat oder ein IMS-Substrat oder ein Reinstsilizium-Stück ist.

7. Entwärmungsanordnung (20) nach Anspruch 6, **dadurch gekennzeichnet, dass** eine erste Kupferstruktur die erste lötbare Oberfläche (26.1) des mittleren Fügepartners (26) und eine zweite Kupferstruktur die zweite lötbare Oberfläche (26.2) des mittleren Fügepartners (26) ausbildet.

8. Halbleiterleistungsmodul (1) mit mehreren Halbleiterbauteilen (3L, 7A, 7B) und mindestens einer Entwärmungsanordnung (20), welche nach einem der Ansprüche 1 bis 7 ausgeführt ist, wobei die Halbleiterbauteile (7A, 7B, 3L) jeweils zwischen einer Emitterleiterbahn (9B), an welcher ein erstes Spannungspotential anliegen kann, und einer als Wärmesenke wirkenden Kollektorleiterbahn (11B) angeordnet sind, an welcher ein zweites Spannungspotential anliegen kann, und wobei die mindestens eine Entwärmungsanordnung (20) einen elektrisch isolierten Entwärmungspfad zwischen der Emitterleiterbahn (9B) und der als Wärmesenke wirkenden Kollektorleiterbahn (11B) ausbildet.

9. Verfahren zum Verbinden eines Schichtstapels aus drei Fügepartnern (24, 26, 28) einer Entwärmungsanordnung (20), welche nach einem der Ansprüche 1 bis 7 ausgeführt ist, und bei welcher der als zu entwärmende erste Leiterbahn ausgeführte elektrisch leitende erste Fügepartner (24) und der als zweite Leiterbahn ausgeführte und als Wärmesenke wirkende elektrisch leitende zweite Fügepartner (28) in ihrer Höhe fixiert sind und einen vorgegebenen Abstand (H) zueinander aufweisen, mit folgenden Schritten:
Aufbringen einer ersten Lotpaste, deren erstes Lotmittel eine erste Schmelztemperatur aufweist, auf eine lötbare Oberfläche des elektrisch leitenden ersten Fügepartners (24) und auf eine erste lötbare Oberfläche (26) des elektrisch isolierenden mittleren Fügepartners (28), so dass ein Spalt zwischen dem ersten Fügepartner (24) und dem mittleren Fügepartner (26) mit der ersten Lotpaste gefüllt ist,
Auffüllen einer nach oben offenen Lotausgleichsöffnung (24.1) im ersten Fügepartner (24) mit der ersten Lotpaste,
Aufbringen einer zweiten Lotpaste, deren zweites Lotmittel eine höhere zweite Schmelztemperatur aufweist, auf eine zweite lötbare Oberfläche (26.2) des mittleren Fügepartners (26) und auf eine lötbare Oberfläche des zweiten Fügepartners (28), so dass ein Spalt zwischen dem mittleren Fügepartner (26) und dem zweiten Fügepartner (28) mit der zweiten Lotpaste gefüllt ist, Erhitzen des Schichtstapels in einem Reflow-Lötofen auf eine Temperatur, welche höher als die zweite Schmelztemperatur ist, und
anschließendes Abkühlen des Schichtstapels, so dass während der Abkühlphase zunächst die zweite Lotschicht (22B) erstarrt, während die erste Lotschicht (22A) noch schmelzflüssig ist, und es zu einem Absinken des mittleren Fügepartners (26) und einer vollflächigen Anbindung des mittleren Fügepartners (26) an den zweiten Fügepartner (28) kommt, wobei der nun größere Spalt zwischen dem mittleren Fügepartner (26) und dem ersten Fügepartner (24) mit dem schmelzflüssigen Lotmittel aus der nach oben offenen Lotausgleichsöffnung (24.1) nachgefüllt wird, so dass es unter Aussparung der Lotausgleichsöffnung (24.1) zu eine vollflächigen Anbindung des mittleren Fügepartners (26) an den ersten Fügepartner (24) kommt.

## Claims

1. Heat extraction assembly (20) for a semiconductor power module (1), with three stacked parts to be joined (24, 26, 28), which are connected to one another in a material-bonded manner by a first solder layer (22A) and by a second solder layer (22B), wherein the first solder layer (22A) is formed between an electrically conducting first part to be joined (24) and an electrically insulating middle part to be joined (26), and the second solder layer (22B) is formed between the electrically insulating middle part to be joined (26) and an electrically conducting second part to be joined (28), wherein the first part to be joined (24) is a first conductor track from which heat is to be extracted, at which a first voltage potential may be present, wherein the second part to be joined (28) is a second conductor track, acting as a heat sink, at which a second voltage potential different from the first voltage potential may be present, and wherein the middle part to be joined (26) has an electrically insulating intermediate layer (26A), which forms an electrically insulated heat-dissipating path between the first part to be joined (24) and the second part to be joined (28),
**characterized in that**
the first solder layer (22A) is formed from a first solder with a first melting temperature, and the second solder layer (22B) is formed from a second solder with a higher, second melting temperature, and wherein the first part to be joined (24) has an upwardly open solder equalization opening (14) which is filled with the first solder and out of which the first solder can continue to flow into the gap between the first part to be joined (24) and the middle part to be joined (26) in order to fill the gap.

2. Heat extraction assembly (20) according to Claim 1, **characterized in that** the electrically insulating intermediate layer (26A) has a good to very good thermal conductivity in the range from 20 to 200 W/mK.

3. Heat extraction assembly (20) according to Claim 1 or 2, **characterized in that** the first part to be joined (24) and the second part to be joined (28) are fixed in their height and are at a predetermined distance (H) from one another.

4. Heat extraction assembly (20) according to Claim 3, **characterized in that**, while leaving the solder equalization opening (24.1) open, the first solder layer (22A) is formed as a solid surface area between a solderable surface of the first part to be joined (24) and a solderable first surface (26.1) of the middle part to be joined (26).

5. Heat extraction assembly (20) according to Claim 3 or 4, **characterized in that** the second solder layer (22B) is formed as a solid surface area between a solderable second surface (26.2) of the middle part to be joined (26) and a solderable surface of the second part to be joined (28).

6. Heat extraction assembly (20) according to one of Claims 1 to 5, **characterized in that** the middle part to be joined (26) is a DBC substrate or an AMB ceramic substrate or an IMS substrate or a piece of high-purity silicon.

7. Heat extraction assembly (20) according to Claim 6, **characterized in that** a first copper structure forms the first solderable surface (26.1) of the middle part to be joined (26) and a second copper structure forms the second solderable surface (26.2) of the middle part to be joined (26).

8. Semiconductor power module (1) with multiple semiconductor components (3L, 7A, 7B) and at least one heat extraction assembly (20), which is configured according to one of Claims 1 to 7, wherein the semiconductor components (3L, 7A, 7B) are each arranged between an emitter conductor track (9B), at which a first voltage potential may be present, and a collector conductor track (11B), acting as a heat sink, at which a second voltage potential may be present, and wherein the at least one heat extraction assembly (20) forms an electrically insulated heat extraction path between the emitter conductor track (9B) and the collector conductor track (11B) acting as a heat sink.

9. Method for connecting a layer stack comprising three parts to be joined (24, 26, 28) of a heat extraction assembly (20), which is configured according to one of Claims 1 to 7, and in which the electrically conducting first part to be joined (24), configured as the first conductor track from which heat is to be extracted, and the electrically conducting second part to be joined (28), configured as the second conductor track and acting as a heat sink, are fixed in their height and are at a predetermined distance (H) from one another, comprising the following steps:
applying a first solder paste, the first solder of which has a first melting temperature, to a solderable surface of the electrically conducting first part to be joined (24) and to a first solderable surface (26) of the electrically insulating middle part to be joined (28), with the result that a gap between the first part to be joined (24) and the middle part to be joined (26) is filled with the first solder paste,
filling an upwardly open solder equalization opening (24.1) in the first part to be joined (24) with the first solder paste,
applying a second solder paste, the second solder of which has a higher, second melting temperature, to a second solderable surface (26.2) of the middle part to be joined (26) and to a solderable surface of the second part to be joined (28), with the result that a gap between the middle part to be joined (26) and the second part to be joined (28) is filled with the second solder paste, heating the layer stack in a reflow soldering oven to a temperature which is higher than the second melting temperature, and
subsequently cooling the layer stack, with the result that, during the cooling phase, first the second solder layer (22B) solidifies, while the first solder layer (22A) is still molten, and the middle part to be joined (26) sinks and the middle part to be joined (26) bonds to the second part to be joined (28) over their full surface area, wherein the now larger gap between the middle part to be joined (26) and the first part to be joined (24) is replenished with the molten solder out of the upwardly open solder equalization opening (24.1), with the result that, while leaving the solder equalization opening (24.1) open, the middle part to be joined (26) bonds to the first part to be joined (24) over their full surface area.

## Revendications

1. Dispositif d'évacuation de chaleur (20) pour un module de puissance à semi-conducteurs (1), comprenant trois partenaires de jonction (24, 26, 28) empilés qui sont reliés entre eux par continuité de matière par une première couche de brasage (22A) et par une seconde couche de brasage (22B), la première couche de brasage (22A) étant formée entre un premier partenaire de jonction (24) électroconducteur et un partenaire de jonction central (26) électriquement isolant, et la seconde couche de brasage (22B) étant formée entre le partenaire de jonction central (26) électriquement isolant et un second partenaire de jonction (28) électroconducteur, le premier partenaire de jonction (24) étant une première piste conductrice à refroidir, à laquelle peut être appliqué un premier potentiel de tension, le second partenaire de jonction (28) étant une seconde piste conductrice agissant comme puits de chaleur, à laquelle peut être appliqué un second potentiel de tension différent du premier potentiel de tension, et le partenaire de jonction central (26) comportant une couche intermédiaire (26A) électriquement isolante qui forme un chemin d'évacuation de chaleur électriquement isolé entre le premier partenaire de jonction (24) et le second partenaire de jonction (28), **caractérisé en ce que**
la première couche de brasage (22A) est formée à partir d'un premier agent de brasage présentant une première température de fusion, et la seconde couche de brasage (22B) est formée à partir d'un second agent de brasage ayant une seconde température de fusion plus élevée, et le premier partenaire de jonction (24) comportant une ouverture d'équilibrage de brasage (14) ouverte vers le haut et remplie du premier agent de brasage, à partir de laquelle le premier agent de brasage peut s'écouler dans l'interstice pour remplir l'interstice entre le premier partenaire de jonction (24) et le partenaire de jonction central (26).

2. Dispositif d'évacuation de chaleur (20) selon la revendication 1, **caractérisé en ce que** la couche intermédiaire (26A) électriquement isolante présente une bonne à très bonne conductivité thermique dans la plage de 20 à 200 W/mK.

3. Dispositif d'évacuation de chaleur (20) selon la revendication 1 ou 2, **caractérisé en ce que** le premier partenaire de jonction (24) et le second partenaire de jonction (28) ont une hauteur fixe et présentent entre eux un espacement (H) prédéfini.

4. Dispositif d'évacuation de chaleur (20) selon la revendication 3, **caractérisé en ce que** la première couche de brasage (22A) est formée par découpe de l'ouverture d'équilibrage de brasage (24.1) sur toute la surface entre une surface brasable du premier partenaire de jonction (24) et une première surface brasable (26.1) du partenaire de jonction intermédiaire (26).

5. Dispositif d'évacuation de chaleur (20) selon la revendication 3 ou 4, **caractérisé en ce que** la seconde couche de brasage (22B) est formée sur toute sa surface entre une seconde surface brasable (26.2) du partenaire de jonction central (26) et une surface brasable du second partenaire de jonction (28).

6. Dispositif d'évacuation de chaleur (20) selon l'une quelconque des revendications 1 à 5, **caractérisé en ce que** le partenaire de jonction central (26) est un substrat DBC ou un substrat céramique AMB ou un substrat IMS ou une pièce de silicium pur.

7. Dispositif d'évacuation de chaleur (20) selon la revendication 6, **caractérisé en ce qu'**une première structure de cuivre forme la première surface brasable (26.1) du partenaire de jonction central (26) et **en ce qu'**une seconde structure de cuivre forme la seconde surface brasable (26.2) du partenaire de jonction central (26) .

8. Module de puissance à semi-conducteurs (1) comportant plusieurs composants semi-conducteurs (3L, 7A, 7B) et au moins un dispositif d'évacuation de chaleur (20) qui est réalisé selon l'une quelconque des revendications 1 à 7, dans lequel les composants semi-conducteurs (7A, 7B, 3L) sont respectivement disposés entre une piste conductrice d'émetteur (9B), à laquelle peut être appliqué un premier potentiel de tension, et une piste conductrice de collecteur (11B) agissant comme puits de chaleur, à laquelle peut être appliqué un second potentiel de tension, et dans lequel le ou les dispositifs d'évacuation de chaleur (20) forment un chemin d'évacuation de chaleur électriquement isolé entre la piste conductrice d'émetteur (9B) et la piste conductrice de collecteur (11B) agissant comme puits de chaleur.

9. Procédé pour relier un empilement de couches constitué de trois partenaires de jonction (24, 26, 28) d'un dispositif d'évacuation de chaleur (20) qui est réalisé selon l'une quelconque des revendications 1 à 7, et dans lequel le premier partenaire de jonction (24) électroconducteur réalisé sous la forme d'une première piste conductrice à refroidir et le second partenaire de jonction (28) électroconducteur réalisé sous la forme d'une seconde piste conductrice agissant comme puits de chaleur ont une hauteur fixe et présentent entre eux un espacement (H) prédéfini, comprenant les étapes suivantes consistant à :
appliquer une première pâte à braser, dont le premier agent de brasage présente une première température de fusion, sur une surface brasable du premier partenaire de jonction (24) électroconducteur et sur une première surface brasable (26) du partenaire de jonction intermédiaire (28) électriquement isolant, de sorte qu'un interstice entre le premier partenaire de jonction (24) et le partenaire de jonction intermédiaire (26) soit rempli de la première pâte à braser,
remplir une ouverture d'équilibrage de brasage (24.1) ouverte vers le haut dans le premier partenaire de jonction (24) de la première pâte à braser,
appliquer une seconde pâte à braser, dont le second agent de brasage présente une seconde température de fusion plus élevée, sur une seconde surface brasable (26.2) du partenaire de jonction central (26) et sur une surface brasable du second partenaire de jonction (28), de sorte qu'un interstice entre le partenaire de jonction central (26) et le second partenaire de jonction (28) soit rempli de la seconde pâte à braser, chauffer l'empilement de couches dans un four de brasage à refusion à une température qui est supérieure à la seconde température de fusion, et
refroidir ensuite l'empilement de couches, de sorte que pendant la phase de refroidissement, la seconde couche de brasage (22B) se solidifie d'abord, tandis que la première couche de brasage (22A) est encore en fusion, et qu'il se produit un affaissement du partenaire de jonction central (26) et une jonction sur toute la surface du partenaire de jonction central (26) avec le second partenaire de jonction (28), l'interstice maintenant plus grand entre le partenaire de jonction central (26) et le premier partenaire de jonction (24) étant rempli de l'agent de brasage en fusion à partir de l'ouverture d'équilibrage de brasage (24.1) ouverte vers le haut, de sorte que la découpe de l'ouverture d'équilibrage de brasage (24.1) entraîne une jonction sur toute la surface du partenaire de jonction central (26) avec le premier partenaire de jonction (24).
